(19) **Europäisches Patentamt / European Patent Office / Office européen des brevets**

(11) **EP 4 568 369 A1**

(12) **EUROPEAN PATENT APPLICATION**
published in accordance with Art. 153(4) EPC

(43) Date of publication:
**11.06.2025 Bulletin 2025/24**

(21) Application number: **23860586.9**

(22) Date of filing: **28.04.2023**

(51) International Patent Classification (IPC):
**H04W 52/52** *(2009.01)*    **H04W 52/28** *(2009.01)*

(52) Cooperative Patent Classification (CPC):
**H04W 52/28; H04W 52/52**

(86) International application number:
**PCT/KR2023/005913**

(87) International publication number:
**WO 2024/048897 (07.03.2024 Gazette 2024/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.08.2022 KR 20220109369**
**06.10.2022 KR 20220128002**

(71) Applicant: **Samsung Electronics Co., Ltd.**
**Suwon-si, Gyeonggi-do 16677 (KR)**

(72) Inventors:
• **NOH, Juseok**
**Suwon-si, Gyeonggi-do 16677 (KR)**
• **JEONG, Daechul**
**Suwon-si, Gyeonggi-do 16677 (KR)**
• **KIM, Seongmin**
**Suwon-si, Gyeonggi-do 16677 (KR)**

(74) Representative: **Gulde & Partner**
**Patent- und Rechtsanwaltskanzlei mbB**
**Berliner Freiheit 2**
**10785 Berlin (DE)**

(54) **METHOD FOR COMPENSATING FOR POWER OF TRANSMISSION SIGNAL, AND ELECTRONIC DEVICE FOR SUPPORTING SAME**

(57) Disclosed is an electronic device comprising: a battery; a communication module including a first processor; and a second processor electrically connected to the battery and the communication module. The first processor may be configured to: detect a transmission event of a Tx signal; request voltage level information about the battery from the second processor in response to detecting the transmission event of the Tx signal; and receive the voltage level information about the battery from the second processor in response to requesting the voltage level information about the battery. The communication module may be configured to compensate for the transmission power level of the Tx signal on the basis of the voltage level information about the battery received by the first processor.

FIG.4

**Description**

**[Technical Field]**

Embodiments of the disclosure relate to a method for compensating for power of a transmission signal, and an electronic device for supporting the same.

**[Background Art]**

A communication function of an electronic device functions as an interface that enables transmission and reception of information resources without temporal and spatial constraints on the operating environment, and various services are being grafted in addition to its central function. Accordingly, various technologies for raising the performance of the communication function, for example, solutions for improving the linearity of a Tx signal (e.g., transmission signal), are being proposed.

The linearity of the Tx signal may be affected by a power supply voltage of an amplifier to which the Tx signal is input. Accordingly, the electronic device may measure the power supply voltage of the amplifier, and use the measured value as a variable to determine whether to compensate for a transmission power of the Tx signal or determine a compensation value.

The above-described content is provided as the background art for the purpose of helping understanding of the disclosure. No claim or determination is made as to whether the above-described content may be applied as the prior art related to the disclosure.

**[Disclosure of Invention]**

**[Technical Problem]**

An electronic device of an embodiment of the disclosure may include a battery, a communication module including a first processor, and a second processor electrically connected to the battery and the communication module. The first processor may be configured to detect a transmission event of a Tx signal, request voltage level information about the battery from the second processor in response to detecting the transmission event of the Tx signal, and receive the voltage level information about the battery from the second processor in response to requesting the voltage level information about the battery. The communication module may be configured to compensate for a transmission power level of the Tx signal, based on the voltage level information about the battery received by the first processor.

A method for compensating for a transmission power of a Tx signal of an embodiment of the disclosure may include detecting a transmission event of a Tx signal by a first processor included in a communication module of an electronic device, requesting, by the first processor, voltage level information about a battery of the electronic device from a second processor of the electronic device in response to detecting the transmission event of the Tx signal, receiving, by the first processor, the voltage level information about the battery from the second processor in response to requesting the voltage level information about the battery, and compensating, by the communication module, for a transmission power level of the Tx signal, based on the voltage level information about the battery received by the first processor.

**[Brief Description of Drawings]**

FIG. 1 is a diagram illustrating an electronic device in a network environment according to an embodiment.
FIG. 2 is a diagram illustrating components of an electronic device according to an embodiment.
FIG. 3 is a diagram illustrating a method for compensating for a transmission power of a signal according to an embodiment.
FIG. 4 is a diagram illustrating an operational relationship between components related to compensation for a transmission power of a signal according to an embodiment.
FIG. 5 is a diagram illustrating another method of compensating for a transmission power of a signal according to an embodiment.
FIG. 6 is a diagram illustrating another operational relationship between components related to compensation for a transmission power of a signal according to an embodiment.
FIG. 7 is a diagram for explaining a relationship between a battery voltage and a power supply voltage of a power amplification module according to an embodiment.
FIG. 8 is a diagram comparing a transmission power compensated based on a battery voltage with a comparison target transmission power by the lapse of time according to an embodiment.

FIG. 9 is a diagram comparing a transmission power compensated based on a battery voltage with a comparison target transmission power in accordance with a level of a battery according to an embodiment.

In relation to the description of the drawings, the same or similar reference numerals may be used for the same or similar components.

**[Mode for the Invention]**

A power supply voltage of an amplifier may be measured by implementing a voltage distribution circuit including a resistance element between the amplifier and a modulator that supplies power to the amplifier, and sensing a power supply voltage node of the amplifier by using the voltage distribution circuit.

However, a method for measuring the power supply voltage of the amplifier by using the voltage distribution circuit may increase a manufacturing cost of an electronic device because of the implementation of the voltage distribution circuit and/or the resistance element included in the voltage distribution circuit, and may act as a constraint on an internal space of the electronic device that is sensitive to integration. In addition, in routing the voltage distribution circuit to the power supply voltage node of the amplifier, when the length of the voltage distribution circuit increases, the power supply voltage of the amplifier may drop and thus the reliability of a measured value may be deteriorated.

Embodiments of the disclosure may present a method and device that may compensate for a transmission power level of a Tx signal, based on a voltage level of a battery.

Various embodiments of the disclosure are described below with reference to the accompanying drawings. However, these are not intended to limit the disclosure to specific embodiment forms, and should be understood as including various modifications, equivalents, and/or alternatives of the embodiments of the disclosure.

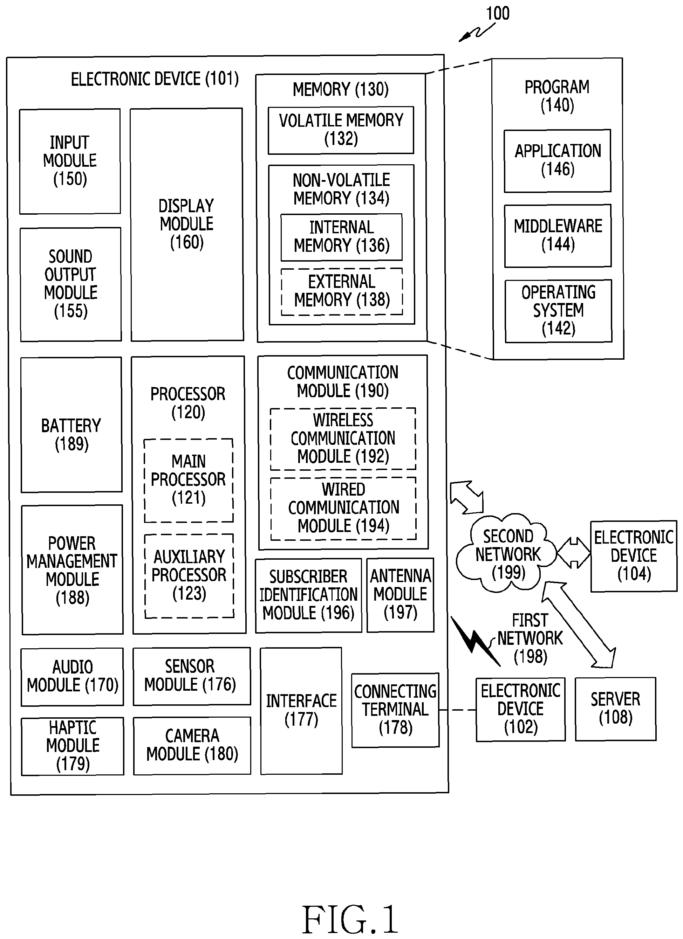

Fig. 1 is a block diagram illustrating an electronic device 101 in a network environment 100 according to various embodiments.

Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

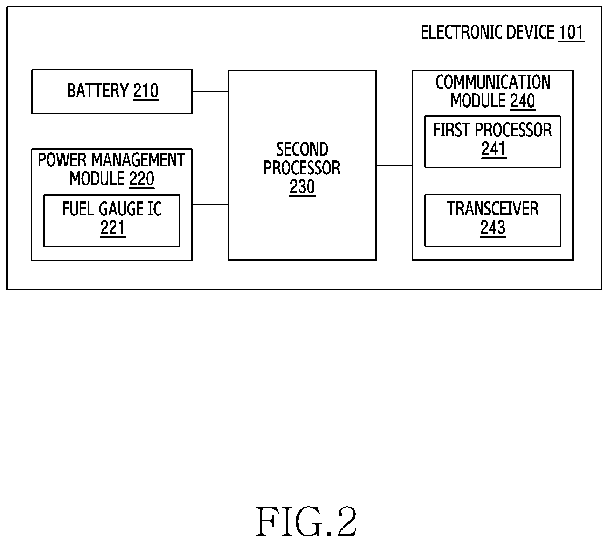

FIG. 2 is a diagram illustrating components of an electronic device according to an embodiment.

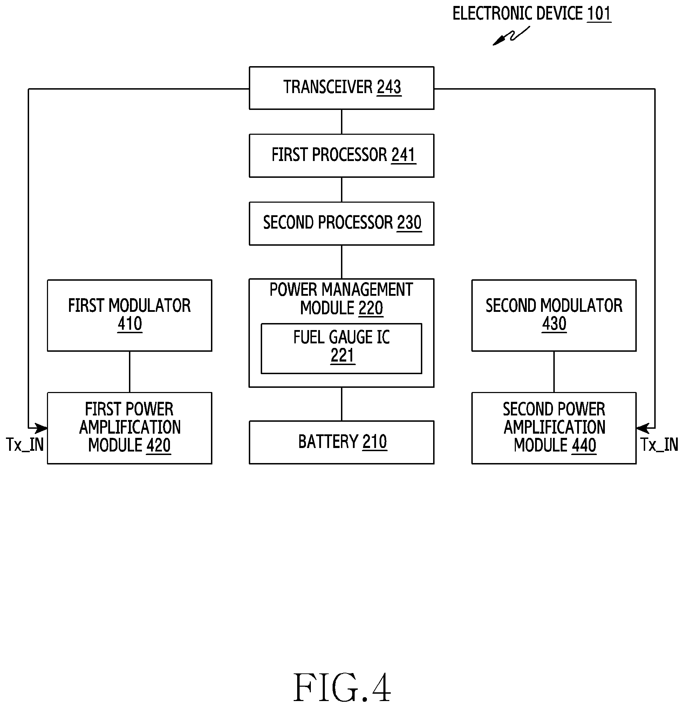

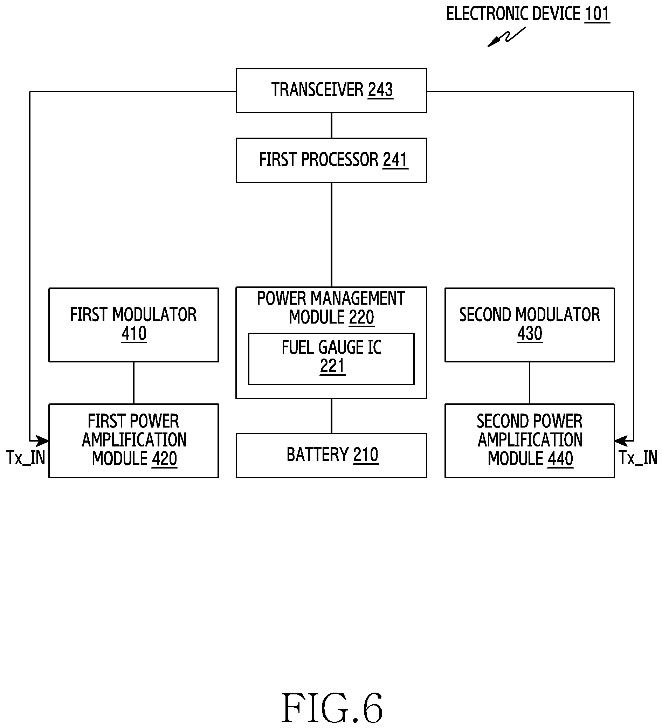

Referring to FIG. 2, the electronic device 101 of an embodiment may include a battery 210, a power management module 220, a second processor 230, and a communication module 240. According to various embodiments, the electronic device 101 may further include additional components in addition to the components described above. For example, the electronic device 101 may further include at least one power amplification module (e.g., first power amplification module 420 and/or second power amplification module 440 of FIG. 4 or FIG. 6) for increasing (or amplifying) a transmission power level of a Tx signal to be transmitted from the electronic device 101. In addition, for example, the electronic device 101 may further include at least one modulator (e.g., first modulator 410 and/or second modulator 430 of FIG. 4 or FIG. 6) for supplying a driving power supply to each of the at least one power amplification module 420 and/or 440. In addition, for example, the electronic device 101 of FIG. 2 may further include at least some of the components included in the electronic device (e.g., electronic device 101 of FIG. 1) mentioned through FIG. 1.

In an embodiment, the battery 210 may be electrically connected to the components of the electronic device 101 and supply power to the components, or may be charged based on power supplied wired or wirelessly from an external power source (e.g., wall power source, auxiliary battery device, wireless charging pad, computer, and/or smartphone). In an embodiment, the battery 210 may include a protection circuit module which performs various functions and decreases the performance degradation or damage of the battery 210.

In an embodiment, the power management module 220 may be electrically connected to the battery 210 and control the overall power management of the electronic device 101. For example, the power management module 220 may charge the battery 210 by using power supplied from the external power source. In this operation, the power management module 220 may determine a method (e.g., normal charging or rapid charging) for charging the battery 210, based on at least one of the type of the external power source, the magnitude of power supplied from the external power source, or the properties of the battery 210. In addition, for example, the power management module 220 may adjust the power of the battery 210 to a voltage level or current level suitable for each component of the electronic device 101 and supply the adjusted power to the corresponding component. According to an embodiment, the power management module 220 may include a power management integrated circuit (PMIC) including at least one buck converter. In an embodiment, the power management module 220 may include a fuel gauge integrated circuit (IC) 221. In an embodiment, the fuel gauge IC 221 may monitor the battery 210 and measure status information (e.g., available capacity, number of charges, number of discharges, lifespan, voltage, and/or temperature) of the battery 210.

In an embodiment, the second processor 230 may be electrically connected to components of the electronic device 101 and execute and control various functions supported by the electronic device 101. For example, the second processor 230 may execute a code of a programming language stored in a memory (e.g., memory 130 of FIG. 1) and control the function and/or operation of the electronic device 101 component, or perform various processing on signals and/or data transmitted from the component. In an embodiment, the second processor 230 may include an application processor (e.g., main processor 121 of FIG. 1).

In an embodiment, the communication module 240 may support wired communication or wireless communication between the electronic device 101 and at least one external device (e.g., communication network operator server and/or external electronic device). In an embodiment, the communication module 240 may include a first processor 241 and a transceiver 243 that are formed as a single chip or single package with the communication module 240. In an embodiment, the first processor 241 may include a communication processor (e.g., auxiliary processor 123 of FIG. 1), and may establish communication being based on a stipulated protocol with the at least one external device, and control transmission and reception of signals and/or data through the established communication. In an embodiment, the transceiver 243 may support transmission of a Tx signal and reception of an Rx signal, and may convert a baseband signal into a radio frequency (RF) signal that may be used for communication with the at least one external device when transmitting the Tx signal, and may convert an RF signal into a baseband signal that may be processed by the first processor 241 when receiving the Rx signal. In an embodiment, the transceiver 243 may include a power amplification module (or power amplification circuit) for increasing (or amplifying) a transmission power level of a Tx signal to be output from the transceiver 243, and an RF driver which controls the operation of the power amplification module.

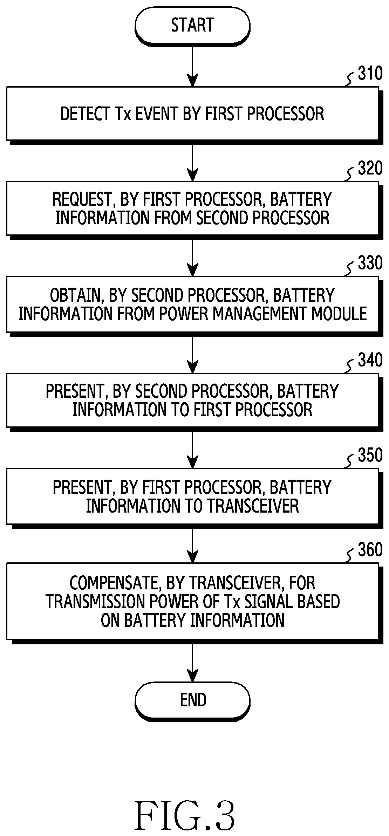

FIG. 3 is a diagram illustrating a method for compensating for a transmission power of a signal according to an embodiment. FIG. 4 is a diagram illustrating an operational relationship between components related to compensation for a transmission power of a signal according to an embodiment.

In describing the embodiment of FIG. 3 below, the embodiment of FIG. 4 may be referred to together. In addition, the operations mentioned in the embodiment of FIG. 3 may be performed sequentially, but may not necessarily be performed sequentially. For example, the order of the operations mentioned in the embodiment of FIG. 3 may be changed, or at least two operations may be performed in parallel.

Referring to FIGS. 3 and 4, in operation 310, the first processor 241 (e.g., communication processor) may detect a transmission event of a Tx signal. For example, when data communication of the electronic device 101 based on at least one of a circuit switching method and a packet switching method is detected, the first processor 241 may determine that the transmission event of the Tx signal has occurred. However, the data communication based on at least one of the circuit switching method and the packet switching method is one example, and the disclosure is not limited to the data communication of this method. For example, the transmission event of the Tx signal may be detected in various communication environments in which the transmission of the Tx signal is involved.

In various embodiments, the first processor 241 may detect the occurrence of the transmission event of the Tx signal at a time when the data communication is actually performed, or detect the occurrence of the transmission event of the Tx signal at a time when an application supporting the data communication is executed. In an embodiment, in response to detecting the transmission event of the Tx signal, the first processor 241 may determine whether an interface supporting the transmission of data and/or signals exists between the first processor 241 and the power management module 220.

In an embodiment, in operation 320, the first processor 241 may request status information about the battery 210 from the second processor 230 (e.g., application processor), based on detecting the transmission event of the Tx signal and determining that no interface with the power management module 220 exists. In this regard, the first processor 241 may be electrically connected to the second processor 230 via an inter process communication (IPC) interface, and the first processor 241 may request voltage level information about the battery 210 from the second processor 230 via the IPC interface.

In an embodiment, the first processor 241 may repeatedly perform the request for the voltage level information about the battery 210 of operation 320 according to a specified period while the transmission event of the Tx signal is maintained. In an embodiment, the specified period may be determined based on the voltage level information about the battery 210 when the voltage level information about the battery 210 requested by the first processor 241 is obtained (or received) from the second processor 230. For example, the first processor 241 may determine the specified period as a first period (e.g., one minute), based on that the obtained voltage level information about the battery 210 indicates a voltage level within a preset low voltage level range. Also, for example, the first processor 241 may determine the specified period as a second period (e.g., five minutes) longer than the first period, based on that the obtained voltage level information about the battery 210 indicates a voltage level within a preset high voltage level range. In an embodiment, the determined first period or second period may be adaptively changed according to the voltage level information about the battery 210 obtained by the first processor 241. For example, the first processor 241 may request the voltage level information about the battery 210 according to the second period, based on that the voltage level information about the battery 210 obtained according to the first period indicates the voltage level within the high voltage level range.

According to an embodiment, in operation 330, in response to the request of the first processor 241, the second processor 230 may obtain (or receive) the voltage level information about the battery 210 from the fuel gauge IC 221 of the power management module 220 electrically connected. For example, the second processor 230 may access the power management module 220 and read a voltage level of the battery 210 measured by the fuel gauge IC 221 of the power management module 220, or request the voltage level information about the battery 210 from the power management module 220 and receive the voltage level information about the battery 210.

According to an embodiment, in operation 340, the second processor 230 may present the obtained voltage level information about the battery 210 to the first processor 241 through the IPC interface and thus, the first processor 241 may obtain the voltage level information about the battery 210 requested from the second processor 230.

According to an embodiment, in operation 350, the first processor 241 may present the obtained voltage level information about the battery 210 to the transceiver 243. For example, the first processor 241 may transmit the voltage level information about the battery 210 to an RF driver of the transceiver 243 that is configured as a single chip or single package with the first processor 241.

According to an embodiment, in operation 360, the transceiver 243 may compensate for a transmission power level of a Tx signal to be transmitted from the electronic device 101 according to a transmission event of the Tx signal, based on the voltage level information about the battery 210 presented from the first processor 241. For example, the RF driver of the transceiver 243 may determine a compensation value for the transmission power level of the Tx signal by using Equation 1 below.

[Equation 1]

$$\text{Compensation value} = (\text{reference voltage level - battery voltage level}) \times \text{NV data value}$$

According to an embodiment, the RF driver of the transceiver 243 may apply a voltage level of the battery 210 as a variable to Equation 1. For example, the RF driver of the transceiver 243 may determine a compensation value for compensating for the transmission power level of the Tx signal, by performing a series of calculation processes of subtracting the voltage level of the battery 210 applied as the variable from a preset reference voltage level and then multiplying a data value (e.g., NV data value) previously stored in a non-volatile (NV) area of a memory (e.g., non-volatile memory 134 of FIG. 1), based on Equation 1.

In an embodiment, the reference voltage level may be set to a high voltage level (e.g., voltage level between about 3.8 V and about 3.9 V). Based on this, when the voltage level information about the battery 210 indicates a high voltage level, the compensation value for the transmission power level of the Tx signal calculated from Equation 1 may be determined to be a relatively small first magnitude. Conversely, when the voltage level information about the battery 210 indicates a low voltage level, the compensation value for the transmission power level of the Tx signal calculated from Equation 1 may be determined as a relatively large second magnitude (or a second magnitude greater than the first magnitude). In various embodiments, the reference voltage level and the NV data value may be recorded as binary data in a memory (e.g., nonvolatile memory 134 of FIG. 1) of the electronic device 101, and may be changed according to the properties (e.g., model, specifications, and/or battery 210 capacity) of the electronic device 101.

In addition, for example, the RF driver of the transceiver 243 may determine the compensation value for the transmission power level of the Tx signal, by using a lookup table stored in the memory (e.g., memory 130 of FIG. 1) of the electronic device 101. In this regard, the memory 130 may store the lookup table in which a corresponding compensation value is defined for each voltage level of the battery 210. In an embodiment, when the RF driver of the transceiver 243 receives the voltage level information about the battery 210 from the first processor 241, the RF driver of the transceiver 243 may determine a compensation value corresponding to a voltage level of the battery 210 with reference to the lookup table of the memory 130. In an embodiment, the compensation value determined from the lookup table may be determined as the relatively small first magnitude when the voltage level information about the battery 210 indicates the high voltage level, and may be determined as the relatively large second magnitude (or the second magnitude larger than the first magnitude) when the voltage level information about the battery 210 indicates the low voltage level.

In an embodiment, the RF driver of the transceiver 243 may control a power amplification module (or power amplification circuit) included in the transceiver 243 to increase a transmission power level of a Tx signal by the determined compensation value, based on determining the compensation value corresponding to the voltage level of the battery 210 by using Equation 1 or the lookup table.

In an embodiment, the Tx signal whose transmission power level is increased (or compensated) by the power amplification module of the transceiver 243 may be output from the transceiver 243 and input to the first power amplification module 420 or the second power amplification module 440. For example, the Tx signal output from the transceiver 243 may be input to the first power amplification module 420 of processing a signal of a first frequency band (e.g., low frequency band) or the second power amplification module 440 of processing a signal of a second frequency band (e.g., intermediate frequency band and high frequency band), in accordance with a frequency band of the Tx signal. In an embodiment, each of the first power amplification module 420 and the second power amplification module 440 may include at least one of a low noise amplifier, a power amplifier, and a duplexer, and may increase the transmission power level of the Tx signal that is input from the transceiver 243.

In an embodiment, the transmission power level of the Tx signal to be transmitted from the electronic device 101 according to the occurrence of a transmission event of the Tx signal may be first increased (or compensated) in the transceiver 243, based on the voltage level information about the battery 210, and may be input from the transceiver 243 to the first power amplification module 420 or the second power amplification module 440 and be secondly increased (or compensated). In this regard, the first power amplification module 420 and the second power amplification module 440 may have a limited gain (or uncontrollable gain) in increasing the transmission power level of the Tx signal, and when the transmission power level of the Tx signal is not increased (or compensated) by the transceiver 243, the transmission power level of the Tx signal increased (or compensated) by the first power amplification module 420 or second power amplification module 440 may not be satisfied with a specified (or intended) level. Therefore, in order for the Tx signal to be transmitted from the electronic device 101 at a specified transmission power level, the transmission power level of the Tx signal may be first increased by the transceiver 243 and be secondarily increased by the first power amplification module 420 or the second power amplification module 440. In an embodiment, the first power amplification module 420 and the second power amplification module 440 may be electrically connected to the first modulator 410 and the second modulator 430 being based on an envelope tracking (ET) interface or an average power tracking (APT) interface, respectively, and receive a driving power supply.

In an embodiment, the first processor 241 may detect that the transmission event of the Tx signal is terminated. For example, when the data communication of the electronic device 101 is not performed for a specified period of time or when the execution of an application related to the data communication that was being executed is terminated, the first processor 241 may determine that the transmission event of the Tx signal is terminated. In an embodiment, even when the transmission event of the Tx signal is terminated, the first processor 241 may obtain the voltage level information about the battery 210. In this regard, the first processor 241 may determine a period for requesting (or obtaining or receiving) the voltage level information about the battery 210 while the termination of the transmission event of the Tx signal is maintained, based on the voltage level information about the battery 210 that is requested and obtained from the second processor 230 after the termination of the transmission event of the Tx signal. For example, the first processor 241 may determine the period as a third period (e.g., ten minutes), based on that the voltage level information about the battery 210 obtained from the second processor 230 after the termination of the transmission event of the Tx signal indicates a voltage level within a preset low voltage level range. Also, for example, the first processor 241 may determine the period as a fourth period (e.g., thirty minutes) longer than the third period, based on that the voltage level information about the battery 210 obtained from the second processor 230 after the termination of the transmission event of the Tx signal indicates a voltage level within a preset high voltage level range.

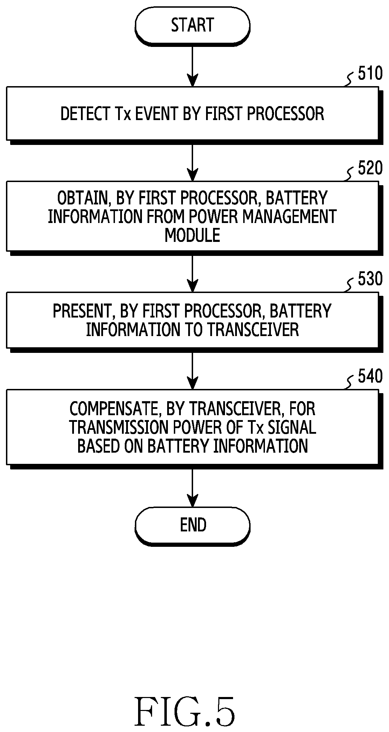

FIG. 5 is a diagram illustrating another method of compensating for a transmission power of a signal according to an embodiment. FIG. 6 is a diagram illustrating another operational relationship between components related to compensation for a transmission power of a signal according to an embodiment.

In describing the embodiment of FIG. 5 below, the embodiment of FIG. 6 may be referred to together. In addition, the operations mentioned in the embodiment of FIG. 5 may be performed sequentially, but may not necessarily be performed sequentially. For example, the order of the operations mentioned in the embodiment of FIG. 5 may be changed, or at least two operations may be performed in parallel.

In addition, at least some of the operations of the electronic device described through FIGS. 5 and 6 may be identical or similar to the operations of the electronic device described through FIGS. 3 and 4 above, and any repeated descriptions of the identical or similar operations of the electronic devices may be omitted or be briefly described below.

Referring to FIGS. 5 and 6, in operation 510, the first processor 241 (e.g., communication processor) may detect a transmission event of a Tx signal. For example, when the first processor 241 detects data communication of the electronic device 101 being based on at least one of a circuit switching method and a packet switching method, the first processor 241 may determine that the transmission event of the Tx signal has occurred. In an embodiment, in response to detecting the transmission event of the Tx signal, the first processor 241 may determine whether an interface supporting transmission of data and/or signals exists between the first processor 241 and the power management module 220.

In an embodiment, in operation 520, the first processor 241 may obtain status information about the battery 210 from the power management module 220, based on the detection of the transmission event of the Tx signal and the existence of the interface with the power management module 220. For example, the first processor 241 may access the power management module 220 and read a voltage level of the battery 210 measured by the fuel gauge IC 221 of the power management module 220, or may request and receive voltage level information about the battery 210 from the power management module 220.

In an embodiment, the first processor 241 may repeatedly perform acquisition of the voltage level information about the battery 210 of operation 520 according to a specified period while the transmission event of the Tx signal is maintained. In an embodiment, the specified period may be determined based on the voltage level information about the battery 210 obtained by the first processor 241. For example, the first processor 241 may determine the specified period as a first period (e.g., one minute), based on that the obtained voltage level information about the battery 210 indicates a voltage level within a preset low voltage level range. In addition, for example, the first processor 241 may determine the specified period as a second period (e.g., five minutes) longer than the first period, based on that the obtained voltage level information about the battery 210 indicates a voltage level within a preset high voltage level range. In an embodiment, the determined first period or second period may be adaptively changed based on the voltage level information about the battery 210 obtained by the first processor 241.

According to an embodiment, in operation 530, the first processor 241 may transmit the obtained voltage level information about the battery 210 to the transceiver 243. For example, the first processor 241 may transmit the voltage level information about the battery 210 to the RF driver of the transceiver 243.

According to an embodiment, in operation 540, the transceiver 243 may compensate for a transmission power level of the Tx signal to be transmitted from the electronic device 101 according to the transmission event of the Tx signal, based on the voltage level information about the battery 210 presented from the first processor 241. For example, the RF driver of the transceiver 243 may determine a compensation value corresponding to a voltage level of the battery 210 by using Equation 1 or the lookup table referred to above, and control the power amplification module (or power amplification circuit) of the transceiver 243 to increase (or compensate for) the transmission power level of the Tx signal by the determined compensation value.

In an embodiment, the Tx signal whose transmission power level is increased (or compensated) by the power amplification module of the transceiver 243 may be output from the transceiver 243 and be input to the first power amplification module 420 or the second power amplification module 440. In an embodiment, the first power amplification module 420 or the second power amplification module 440 may process the input Tx signal and increase the transmission power level of the Tx signal.

In an embodiment, the first processor 241 may detect that the transmission event of the Tx signal is terminated.

For example, when the data communication of the electronic device 101 is not performed for a specified period of time or when the execution of an application related to the data communication that was being executed is terminated, the first processor 241 may determine that the transmission event of the Tx signal is terminated. In an embodiment, the first processor 241 may obtain voltage level information about the battery 210 even after the transmission event of the Tx signal is terminated. For example, the first processor 241 may obtain the voltage level information about the battery 210 according to a third period (e.g., ten minutes) while the termination of the transmission event of the Tx signal is maintained, based on that the voltage level information about the battery 210 obtained from the power management module 220 after the termination of the transmission event of the Tx signal indicates a voltage level within a preset low voltage level range. Also, for example, the first processor 241 may obtain the voltage level information about the battery 210 according to a fourth period (e.g., thirty minutes) while the termination of the transmission event of the Tx signal is maintained, based on that the voltage level information about the battery 210 obtained from the power management module 220 after the termination of the transmission event of the Tx signal indicates a voltage level within a preset high voltage level range.

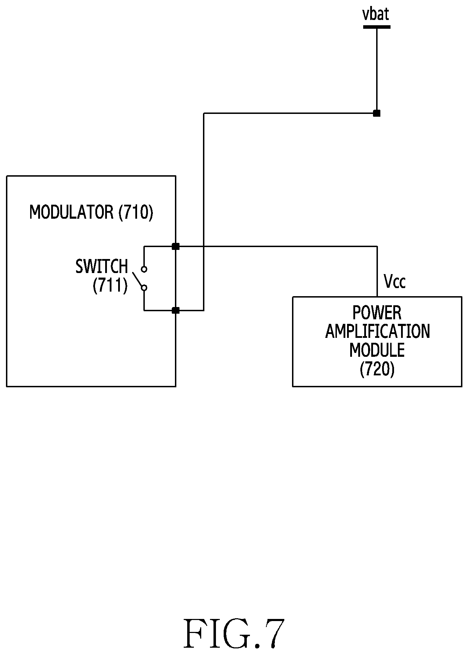

FIG. 7 is a diagram for explaining a relationship between a battery voltage and a power supply voltage of a power amplification module according to an embodiment.

Referring to FIG. 7, a battery (e.g., battery 210 of FIG. 2, FIG. 4, or FIG. 6) of an embodiment may supply power to a modulator 710 (e.g., first modulator 410 and/or second modulator 430 of FIG. 4 or FIG. 6) that supplies a driving power supply to a power amplification module 720 (e.g., first power amplification module 420 and/or second power amplification module 440 of FIG. 4 or FIG. 6). For example, the power of the battery 210 may be supplied to the power amplification module 720, based on the operation of a switch 711 included in the modulator 710.

In an embodiment, the switch 711 inside the modulator 710 may have a relatively small resistance value (or Ron value) and accordingly, the loss of power supplied from the battery 210 to the power amplification module 720 via the modulator 710 may be small. For example, a voltage level Vbat of the battery 210 may be at a similar level to a power voltage level Vcc of the power amplification module 720 sensed at a power voltage node of the power amplification module 720.

[Table 1]

| JIG | Vbat | Vcc | Delta |
| --- | --- | --- | --- |
| 4300 | 4225 mV | 4180 mV | 45 mV |
| 4200 | 4176 mV | 4160 mV | 16 mV |
| 4100 | 4194 mV | 4130 mV | 64 mV |
| 4000 | 4144 mV | 4087 mV | 57 mV |
| 3900 | 4037 mV | 4000 mV | 37 mV |
| 3800 | 3961 mV | 3910 mV | 51 mV |
| 3700 | 3837 mV | 3860 mV | -23 mV |
| 3600 | 3757 mV | 3750 mV | 7 mV |
| 3500 | 3613 mV | 3670 mV | -57 mV |
| 3400 | 3518 mV | 3540 mV | -22 mV |
| 3300 | 3400 mV | 3450 mV | -50 mV |

Table 1 shows the comparison between a battery voltage and a power voltage of a power amplification module according to an embodiment. Referring to Table 1 showing a difference between a voltage level Vbat of the battery 210 and a power voltage level Vcc of the power amplification module 720 for each JIG voltage, it may be determined that a difference value Delta between the voltage level Vbat of the battery 210 and the power voltage level Vcc of the power amplification module 720 is a small level of about 60 mV.

According to an embodiment, the electronic device (e.g., electronic device 101 of FIG. 2, FIG. 4, or FIG. 6) may compensate for the transmission power level for transmitting the Tx signal, based on the voltage level information about the battery 210. Accordingly, in the electronic device 101, a process of measuring a power voltage of the power amplification module 720 used to compensate for the transmission power level of the Tx signal may be omitted, and a circuit and component used to measure the power voltage of the power amplification module 720 may also be omitted.

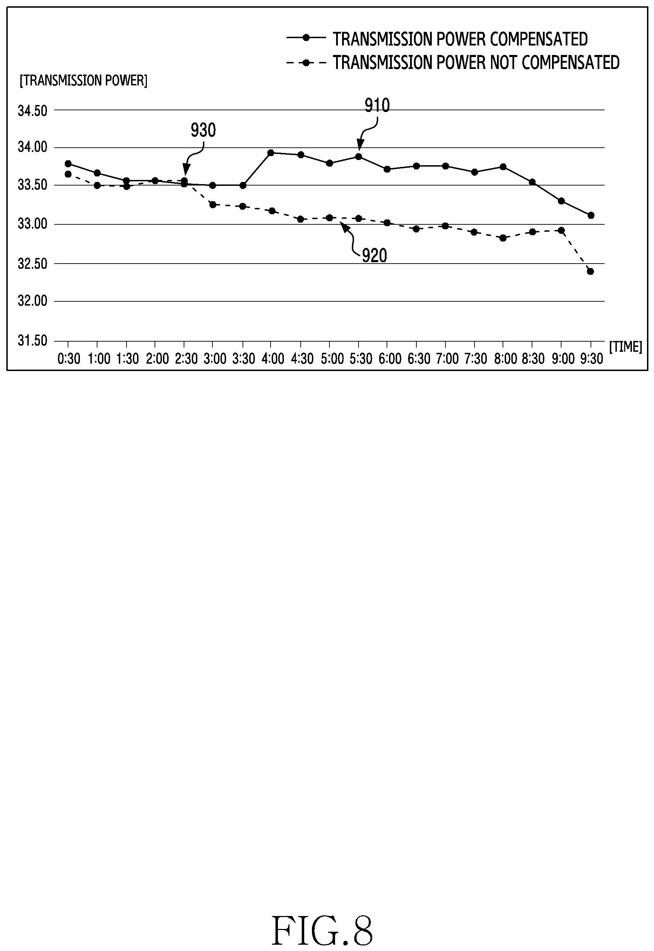

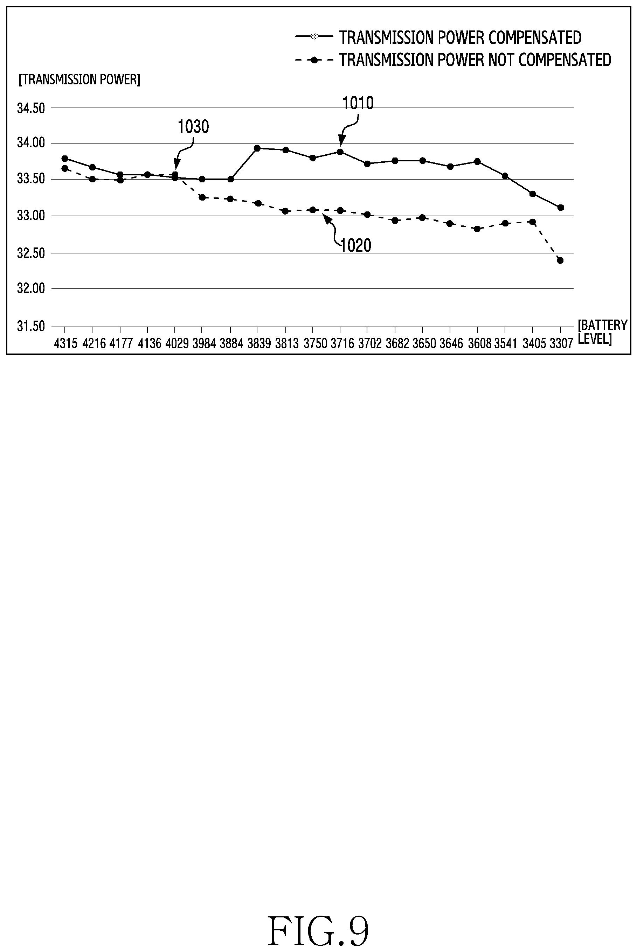

FIG. 8 is a diagram comparing a transmission power compensated based on a battery voltage with a comparison target transmission power by the lapse of time according to an embodiment. FIG. 9 is a diagram comparing a transmission power compensated based on a battery voltage with a comparison target transmission power by the lapse of time according to an embodiment.

Referring to FIGS. 8 and 9, while a transmission event of a Tx signal is maintained, a voltage level of a battery may decrease by the lapse of time. Looking at a section (e.g., section before two minutes and thirty seconds or section of battery level of 4.314 V to 4.029 V) before a point of time 930 or 1030 at which the voltage level of the battery switches from a high voltage to a low voltage, it may be determined that a transmission power level 910 or 1010 of a Tx signal compensated based on voltage level information about a battery according to an embodiment and a transmission power level 920 or 1020 of a comparison target Tx signal (e.g., transmission power level of Tx signal not compensated) are at similar levels.

However, looking at a section (e.g., section after two minutes and thirty seconds or section of battery level of 3.984 V to 3.307 V) after a point of time 930 or 1030 at which the voltage level of the battery switches from a high voltage to a low voltage, the transmission power level 910 or 1010 of the Tx signal compensated based on the voltage level information about the battery and the transmission power level 920 or 1020 of the comparison target Tx signal may have a significant difference of level magnitude, and it may be determined that the transmission power level 910 or 1010 of the Tx signal compensated based on the voltage level information about the battery is maintained similar to the level when the voltage level of the battery is a high voltage.

[Table 2]

| Time | Transmission Power Compensated | | | | Transmission Power Not Compensated | | | |
|---|---|---|---|---|---|---|---|---|
| | Voltage (mV) | Level (%) | Level Block (0~8) | Power (dBm) | Voltage (mV) | Level (%) | Level Block (0~8) | Power (dBm) |
| 0:30 | 4315 | 100 | 8 | 33.80 | 4278 | 100 | 8 | 33.65 |
| 1:00 | 4216 | 94 | 7 | 33.67 | 4243 | 94 | 7 | 33.51 |
| 1:30 | 4177 | 89 | 7 | 33.57 | 4162 | 88 | 7 | 33.50 |
| 2:00 | 4136 | 85 | 7 | 33.57 | 4112 | 83 | 7 | 33.58 |
| 2:30 | 4029 | 79 | 6 | 33.54 | 4047 | 78 | 6 | 33.58 |
| 3:00 | 3984 | 71 | 6 | 33.50 | 3897 | 69 | 6 | 33.26 |
| 3:30 | 3884 | 65 | 6 | 33.5 | 3881 | 64 | 5 | 33.23 |
| 4:00 | 3839 | 60 | 5 | 33.93 | 3846 | 59 | 5 | 33.18 |
| 4:30 | 3813 | 53 | 5 | 33.9 | 3811 | 54 | 5 | 33.07 |
| 5:00 | 3750 | 47 | 4 | 33.81 | 3764 | 48 | 4 | 33.09 |
| 5:30 | 3716 | 41 | 4 | 33.88 | 3729 | 42 | 4 | 33.08 |
| 6:00 | 3702 | 36 | 4 | 33.72 | 3713 | 37 | 4 | 33.03 |
| 6:30 | 3682 | 30 | 3 | 33.76 | 3707 | 32 | 3 | 32.95 |
| 7:00 | 3650 | 20 | 2 | 33.76 | 3671 | 24 | 3 | 32.99 |
| 7:30 | 3646 | 14 | 2 | 33.68 | 3656 | 19 | 2 | 32.9 |
| 8:00 | 3608 | 8 | 1 | 33.75 | 3633 | 14 | 2 | 32.83 |
| 8:30 | 3541 | 3 | 0 | 33.55 | 3560 | 9 | 1 | 32.9 |
| 9:00 | 3405 | 1 | 0 | 33.31 | 3550 | 6 | 1 | 32.93 |
| 9:30 | 3307 | 1 | 0 | 33.13 | 3557 | 1 | 0 | 32.4 |

Table 2 shows the comparison of a transmission power compensated based on a battery voltage and a comparison target transmission power by the lapse of time and a battery level according to an embodiment. Referring to Table 2, it may be determined that the magnitude of a transmission power level of a comparison target Tx signal (e.g., transmission power level of Tx signal not compensated) decreases to a certain level or more in a section where a voltage level of a battery is a low voltage (e.g., section after two minutes and thirty seconds or section of battery level of 3.897 V to 3.557 V), compared to a section where the voltage level of the battery is a high voltage (e.g., section before two minutes and thirty seconds or section of battery level of 4.278 V to 4.047 V).

However, when a transmission power level of a Tx signal is compensated based on voltage level information about the battery according to an embodiment, it may be determined that the magnitude of the compensated transmission power level of the Tx signal is maintained at a similar level in a section where the voltage level of the battery is a high voltage (e.g., section before two minutes and thirty seconds or section of battery level of 4.315 V to 4.029 V) and a section where the voltage level of the battery is a low voltage (e.g., section after two minutes and thirty seconds or section of battery level of 3.984 V to 3.330 V).

An electronic device of an embodiment of the disclosure may include a battery, a communication module including a first processor, and a second processor electrically connected to the battery and the communication module.

According to an embodiment of the disclosure, the first processor may detect a transmission event of a Tx signal, request voltage level information about the battery from the second processor in response to detecting the transmission event of the Tx signal, and receive the voltage level information about the battery from the second processor in response to requesting the voltage level information about the battery.

According to an embodiment of the disclosure, the communication module may compensate for a transmission power level of the Tx signal, based on the voltage level information about the battery received by the first processor.

According to an embodiment of the disclosure, the electronic device may further include a power management module which is electrically connected to the battery and includes a fuel gauge circuit.

According to an embodiment of the disclosure, the first processor may determine whether a data interface exists between the first processor and the power management module in response to detecting the transmission event of the Tx signal, and request the voltage level information about the battery from the second processor in response to determining that no data interface exists.

According to an embodiment of the disclosure, the second processor may obtain the voltage level information about the battery from the power management module in response to receiving the request for the voltage level information about the battery from the first processor, and transmit the obtained voltage level information about the battery to the first processor.

According to an embodiment of the disclosure, the first processor may request the voltage level information about the battery from the second processor according to a first period while the transmission event of the Tx signal is maintained in response to that the voltage level information about the battery received from the second processor indicates a voltage level within a specified low voltage level range, and request the voltage level information about the battery from the second processor according to a second period longer than the first period while the transmission event of the Tx signal is maintained in response to that the voltage level information about the battery received from the second processor indicates a voltage level within a specified high voltage level range.

According to an embodiment of the disclosure, the communication module may further include a transceiver including an RF driver and a first power amplification module.

According to an embodiment of the disclosure, the RF driver may receive the voltage level information about the battery from the first processor, and determine a compensation value for compensating for the transmission power level of the Tx signal, based on the voltage level information about the battery.

According to an embodiment of the disclosure, the RF driver may determine the compensation value as a first magnitude in response to that the voltage level information about the battery indicates the voltage level within the specified high voltage level range, and determine the compensation value as a second magnitude greater than the first magnitude in response to that the voltage level information about the battery indicates the voltage level within the specified low voltage level range.

According to an embodiment of the disclosure, the RF driver may control the first power amplification module to increase the transmission power level of the Tx signal by the determined compensation value and output the increased transmission power level from the first power amplification module.

According to an embodiment of the disclosure, the electronic device may further include at least one of a second power amplification module which processes a signal of a first frequency band, and a third power amplification module which processes a signal of a second frequency band.

According to an embodiment of the disclosure, the Tx signal, whose transmission power level is increased by the determined compensation value and is output from the first power amplification module, may be input to the second power amplification module or the third power amplification module according to a frequency band of the Tx signal.

According to an embodiment of the disclosure, the first processor may detect the termination of the transmission event of the Tx signal, and in response to detecting the termination of the transmission event of the Tx signal, request voltage level information about the battery from the second processor after the transmission event of the Tx signal is terminated and receive the voltage level information about the battery from the second processor.

According to an embodiment of the disclosure, the first processor may request the voltage level information about the battery from the second processor according to a third period while the termination of the transmission event of the Tx signal is maintained in response to that the voltage level information about the battery received from the second processor after the transmission event of the Tx signal is terminated indicates a voltage level within a specified low voltage level range, and request the voltage level information about the battery from the second processor according to a fourth period longer than the third period while the termination of the transmission event of the Tx signal is maintained in response to that the voltage level information about the battery received from the second processor after the transmission event of the Tx signal is terminated indicates a voltage level within a specified high voltage level range.

A method for compensating for a transmission power of a Tx signal of an embodiment of the disclosure may include detecting a transmission event of a Tx signal by a first processor included in a communication module of an electronic device, requesting, by the first processor, voltage level information about a battery of the electronic device from a second processor of the electronic device in response to detecting the transmission event of the Tx signal, receiving, by the first processor, the voltage level information about the battery from the second processor in response to requesting the voltage level information about the battery, and compensating, by the communication module, for a transmission power level of the Tx signal, based on the voltage level information about the battery received by the first processor.

According to an embodiment of the disclosure, the requesting of the voltage level information about the battery may include determining, by the first processor, whether a data interface exists between the first processor and a power management module including a fuel gauge circuit of the electronic device in response to detecting the transmission event of the Tx signal, and requesting, by the first processor, the voltage level information about the battery from the second processor in response to determining that no data interface exists.

According to an embodiment of the disclosure, the method for compensating for the transmission power of the Tx signal may further include obtaining, by the second processor, the voltage level information about the battery from the power management module in response to receiving the request for the voltage level information about the battery from the first processor, and transmitting, by the second processor, the obtained voltage level information about the battery to the first processor.

According to an embodiment of the disclosure, the requesting of the voltage level information about the battery may include requesting, by the first processor, the voltage level information about the battery from the second processor according to a first period while the transmission event of the Tx signal is maintained in response to that the voltage level information about the battery received from the second processor indicates a voltage level within a specified low voltage level range, and requesting, by the first processor, the voltage level information about the battery from the second processor according to a second period longer than the first period while the transmission event of the Tx signal is maintained in response to that the voltage level information about the battery received from the second processor indicates a voltage level within a specified high voltage level range.

According to an embodiment of the disclosure, the compensating for the transmission power level of the Tx signal may include receiving the voltage level information about the battery from the first processor by an RF driver included in the communication module, and determining, by the RF driver, a compensation value for compensating for the transmission power level of the Tx signal, based on the voltage level information about the battery.

According to an embodiment of the disclosure, the determining of the compensation value may include determining, by the RF driver, the compensation value as a first magnitude in response to that the voltage level information about the battery indicates a voltage level within a specified high voltage level range, and determining, by the RF driver, the compensation value as a second magnitude greater than the first magnitude in response to that the voltage level information about the battery indicates a voltage level within a specified low voltage level range.

According to an embodiment of the disclosure, the compensating for the transmission power level of the Tx signal may further include controlling, by the RF driver, a first power amplification module included in the communication module to increase the transmission power level of the Tx signal by the determined compensation value and output the increased transmission power level of the Tx signal from the first power amplification module.

According to an embodiment of the disclosure, the method for compensating for the transmission power of the Tx signal may further include inputting the Tx signal, whose transmission power level is increased by the determined compensation value and is output from the first power amplification module, to a second power amplification module processing a signal of a first frequency band and a third power amplification module processing a signal of a second frequency band according to a frequency band of the Tx signal.

According to an embodiment of the disclosure, the method for compensating for the transmission power of the Tx signal may further include detecting, by the first processor, the termination of the transmission event of the Tx signal, and in response to detecting the termination of the transmission event of the Tx signal, requesting, by the first processor, voltage level information about the battery from the second processor after the transmission event of the Tx signal is terminated and receive the voltage level information about the battery from the second processor.

According to an embodiment of the disclosure, the method for compensating for the transmission power of the Tx signal may further include requesting, by the first processor, the voltage level information about the battery from the second processor according to a third period while the termination of the transmission event of the Tx signal is maintained in response to that the voltage level information about the battery received from the second processor after the transmission event of the Tx signal is terminated indicates a voltage level within a specified low voltage level range, and requesting, by the first processor, the voltage level information about the battery from the second processor according to a fourth period longer than the third period while the termination of the transmission event of the Tx signal is maintained in response to that the voltage level information about the battery received from the second processor after the transmission event of the Tx signal is terminated indicates a voltage level within a specified high voltage level range.

According to embodiments of the disclosure, a mechanism capable of compensating for a transmission power level of a Tx signal, based on a voltage level of a battery may be presented.

According to embodiments of the disclosure, the transmission power level of the Tx signal optimized for the voltage level of the battery may be supported.

According to embodiments of the disclosure, a manufacturing cost of an electronic device may be reduced since circuits and components used to compensate for the transmission power level of the Tx signal are omitted.

According to embodiments of the disclosure, the design freedom and component integration for an internal space of the electronic device may be improved since the circuits and components used to compensate for the transmission power level of the Tx signal are omitted.

The effects obtainable from the disclosure are not limited to the effects mentioned above, and other effects not mentioned may be clearly understood by a person having ordinary skill in the art from the embodiments of the disclosure.

The electronic device of various embodiments of the disclosure may include various types of devices. The electronic device may include, for example, a portable communication device (e.g., smartphone), a computer device, a portable multimedia device, a portable medical device, a camera, a wearable device, or a home appliance. The electronic device of an embodiment of the disclosure is not limited to the above-described devices.

Various embodiments of the disclosure and terms used herein are not intended to limit the technical features described in the disclosure to specific embodiments, but should be understood as including various modifications, equivalents, or alternatives of the corresponding embodiment. In relation to the description of the drawings, similar reference numerals may be used for similar or related components. The singular form of a noun corresponding to an item may include a single or plurality of items, unless the relevant context clearly indicates otherwise. In the disclosure, each of phrases such as "A or B", "at least one of A and B", "at least one of A or B", "A, B or C", "at least one of A, B and C", and "at least one of A, B, or C" may include any one of items listed together in a corresponding phrase among the phrases, or any possible combination thereof. Terms such as "first", "second", "firstly" or "secondly" may be used simply to distinguish a corresponding component from another corresponding component, and do not limit the corresponding components in other respects (e.g., importance or order). When some (e.g., first) component is mentioned to be "coupled" or "connected" to another (e.g., second) component, with or without the term "functionally" or "communicatively", it means that some component may be connected to another component directly (e.g., wired), wirelessly, or through a third component.

The term "module" used in the disclosure may include a unit implemented in hardware, software, or firmware, and may be used interchangeable with a term such as a logic, a logic block, a component, or a circuit, for example. The module may include an integrated component, or a minimum unit of the component or a part thereof performing one or more functions. For example, according to an embodiment, the module may be implemented in the form of an application-specific integrated circuit (ASIC).

Various embodiments of the disclosure may be implemented as software (e.g., program 140) that includes one or more instructions stored in a storage medium (e.g., internal memory 136 or external memory 138) that is readable by a machine (e.g., electronic device 101). For example, a processor (e.g., processor 120) of the machine (e.g., electronic device 101) may call at least one instruction among the stored one or more instructions from the storage medium, and execute it. This enables the machine to be operated to perform at least one function according to the called at least one instruction. The one or more instructions may include a code provided by a compiler or a code executable by an interpreter. The machine-readable storage medium may be presented in the form of a non-transitory storage medium. Here, 'non-transitory' only means that the storage medium is a tangible device and does not include a signal (e.g., electromagnetic wave). This term does not distinguish a case where data is stored semi-permanently in the storage medium and a case where data is stored temporarily.

According to an embodiment, a method of various embodiments of the disclosure may be included and presented in a computer program product. The computer program product may be traded as merchandise between a seller and a buyer. The computer program product may be distributed in the form of a machine-readable storage medium (e.g., compact disc read only memory (CD-ROM)), or be distributed (e.g., downloaded or uploaded) through an application store (e.g., Play StoreTM), directly between two user devices (e.g., smartphones), or online. In the online distribution, at least part of the computer program product may be at least temporarily stored in the machine-readable storage medium such as a memory of a manufacturer's server, an application store's server, or a relay server, or be temporarily provided.

According to various embodiments, each component (e.g., module or program) of the components described above may include a single or plurality of entities. According to various embodiments, one or more components of the corresponding components mentioned above or operations may be omitted, or one or more other components or operations may be added. Alternatively or additionally, a plurality of components (e.g., modules or programs) may be integrated into a single component. In this case, the integrated component may perform one or more functions of each of the plurality of components, identically or similarly to those performed by the corresponding component among the plurality of components prior to the integration. According to various embodiments, operations performed by a module, program, or another component may be executed sequentially, in parallel, iteratively, or heuristically, or one or more of the operations may be executed in a different order or be omitted, or one or more other operations may be added.

**Claims**

1. An electronic device comprising:

   a battery;
   a communication module comprising a first processor; and
   a second processor electrically connected to the battery and the communication module,
   wherein the first processor is configured to:

   detect a transmission event of a Tx signal;
   request voltage level information about the battery from the second processor in response to detecting the transmission event of the Tx signal; and
   receive the voltage level information about the battery from the second processor in response to requesting the voltage level information about the battery, and
   the communication module is configured to compensate for a transmission power level of the Tx signal, based on the voltage level information about the battery received by the first processor.

2. The electronic device of claim 1, further comprising a power management module which is electrically connected to the battery and comprises a fuel gauge circuit,
   wherein the first processor is configured to:

   determine whether a data interface exists between the first processor and the power management module in response to detecting the transmission event of the Tx signal; and
   request the voltage level information about the battery from the second processor in response to determining that no data interface exists.

3. The electronic device of claim 2, wherein the second processor is configured to:

   obtain the voltage level information about the battery from the power management module in response to receiving the request for the voltage level information about the battery from the first processor; and
   transmit the obtained voltage level information about the battery to the first processor.

4. The electronic device of claim 1, wherein the first processor is configured to:

   request the voltage level information about the battery from the second processor according to a first period while the transmission event of the Tx signal is maintained in response to that the voltage level information about the battery received from the second processor indicates a voltage level within a specified low voltage level range; and
   request the voltage level information about the battery from the second processor according to a second period longer than the first period while the transmission event of the Tx signal is maintained in response to that the voltage level information about the battery received from the second processor indicates a voltage level within a specified high voltage level range.

5. The electronic device of claim 1, wherein the communication module further comprises a transceiver comprising an RF driver and a first power amplification module, and
   the RF driver is configured to:

   receive the voltage level information about the battery from the first processor; and
   determine a compensation value for compensating for the transmission power level of the Tx signal, based on the voltage level information about the battery.

6. The electronic device of claim 5, wherein the RF driver is configured to:

   determine the compensation value as a first magnitude in response to that the voltage level information about the battery indicates the voltage level within the specified high voltage level range; and
   determine the compensation value as a second magnitude greater than the first magnitude in response to that the voltage level information about the battery indicates the voltage level within the specified low voltage level range.

7. The electronic device of claim 5, wherein the RF driver is configured to control the first power amplification module to increase the transmission power level of the Tx signal by the determined compensation value and output the increased transmission power level from the first power amplification module.

8. The electronic device of claim 7, further comprising at least one of:

    a second power amplification module which processes a signal of a first frequency band; and
    a third power amplification module which processes a signal of a second frequency band, and
    wherein the Tx signal, whose transmission power level is increased by the determined compensation value and is output from the first power amplification module, is input to the second power amplification module or the third power amplification module according to a frequency band of the Tx signal.

9. A method for compensating for a transmission power of a Tx signal, comprising:

    detecting a transmission event of a Tx signal by a first processor comprised in a communication module of an electronic device;
    requesting, by the first processor, voltage level information about a battery of the electronic device from a second processor of the electronic device in response to detecting the transmission event of the Tx signal;
    receiving, by the first processor, the voltage level information about the battery from the second processor in response to requesting the voltage level information about the battery; and
    compensating, by the communication module, for a transmission power level of the Tx signal, based on the voltage level information about the battery received by the first processor.

10. The method for compensating for the transmission power of the Tx signal of claim 9, wherein the requesting of the voltage level information about the battery comprises:

    determining, by the first processor, whether a data interface exists between the first processor and a power management module comprising a fuel gauge circuit of the electronic device in response to detecting the transmission event of the Tx signal; and
    requesting, by the first processor, the voltage level information about the battery from the second processor in response to determining that no data interface exists.

11. The method for compensating for the transmission power of the Tx signal of claim 10, further comprising:

    obtaining, by the second processor, the voltage level information about the battery from the power management module in response to receiving the request for the voltage level information about the battery from the first processor; and
    transmitting, by the second processor, the obtained voltage level information about the battery to the first processor.

12. The method for compensating for the transmission power of the Tx signal of claim 9, wherein the requesting of the voltage level information about the battery comprises:

    requesting, by the first processor, the voltage level information about the battery from the second processor according to a first period while the transmission event of the Tx signal is maintained in response to that the voltage level information about the battery received from the second processor indicates a voltage level within a specified low voltage level range; and
    requesting, by the first processor, the voltage level information about the battery from the second processor according to a second period longer than the first period while the transmission event of the Tx signal is maintained in response to that the voltage level information about the battery received from the second processor indicates a voltage level within a specified high voltage level range.

13. The method for compensating for the transmission power of the Tx signal of claim 9, wherein the compensating for the transmission power level of the Tx signal comprises:

    receiving the voltage level information about the battery from the first processor by an RF driver comprised in the communication module; and
    determining, by the RF driver, a compensation value for compensating for the transmission power level of the Tx signal, based on the voltage level information about the battery.

14. The method for compensating for the transmission power of the Tx signal of claim 13, wherein the determining of the compensation value comprises:

determining, by the RF driver, the compensation value as a first magnitude in response to that the voltage level information about the battery indicates a voltage level within a specified high voltage level range; and determining, by the RF driver, the compensation value as a second magnitude greater than the first magnitude in response to that the voltage level information about the battery indicates a voltage level within a specified low voltage level range.

15. The method for compensating for the transmission power of the Tx signal of claim 13, wherein the compensating for the transmission power level of the Tx signal comprises:
controlling, by the RF driver, a first power amplification module comprised in the communication module to increase the transmission power level of the Tx signal by the determined compensation value and output the increased transmission power level of the Tx signal from the first power amplification module.

FIG.1

ELECTRONIC DEVICE 101

BATTERY 210

POWER MANAGEMENT MODULE 220

FUEL GAUGE IC 221

SECOND PROCESSOR 230

COMMUNICATION MODULE 240

FIRST PROCESSOR 241

TRANSCEIVER 243

# FIG.2

FIG.3

ELECTRONIC DEVICE 101

TRANSCEIVER 243

FIRST PROCESSOR 241

SECOND PROCESSOR 230

| FIRST MODULATOR 410 | POWER MANAGEMENT MODULE 220 | SECOND MODULATOR 430 |
|---|---|---|
| | FUEL GAUGE IC 221 | |

Tx_IN

| FIRST POWER AMPLIFICATION MODULE 420 | BATTERY 210 | SECOND POWER AMPLIFICATION MODULE 440 |

Tx_IN

FIG.4

START

510
DETECT Tx EVENT BY FIRST PROCESSOR

520
OBTAIN, BY FIRST PROCESSOR, BATTERY
INFORMATION FROM POWER MANAGEMENT
MODULE

530
PRESENT, BY FIRST PROCESSOR, BATTERY
INFORMATION TO TRANSCEIVER

540
COMPENSATE, BY TRANSCEIVER, FOR
TRANSMISSION POWER OF Tx SIGNAL
BASED ON BATTERY INFORMATION

END

FIG.5

ELECTRONIC DEVICE 101

TRANSCEIVER 243

FIRST PROCESSOR 241

FIRST MODULATOR 410

POWER MANAGEMENT MODULE 220

FUEL GAUGE IC 221

SECOND MODULATOR 430

FIRST POWER AMPLIFICATION MODULE 420

Tx_IN

BATTERY 210

SECOND POWER AMPLIFICATION MODULE 440

Tx_IN

FIG.6

vbat

MODULATOR (710)

SWITCH
(711)

Vcc

POWER
AMPLIFICATION
MODULE
(720)

# FIG.7

FIG.8

FIG.9

## INTERNATIONAL SEARCH REPORT

| International application No. |
|---|
| **PCT/KR2023/005913** |

**A. CLASSIFICATION OF SUBJECT MATTER**

**H04W 52/52**(2009.01)i; **H04W 52/28**(2009.01)i

According to International Patent Classification (IPC) or to both national classification and IPC

**B. FIELDS SEARCHED**

Minimum documentation searched (classification system followed by classification symbols)

H04W 52/52(2009.01); H04B 1/02(2006.01); H04B 1/04(2006.01); H04B 1/40(2006.01); H04B 1/62(2006.01); H04L 27/18(2006.01); H04W 52/36(2009.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 송신 이벤트(transmission event), 전압 레벨 정보(power level information), 송신 전력 레벨(transmission power level), 보상(compensation)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2006-0021666 A (LG ELECTRONICS INC.) 08 March 2006 (2006-03-08) See paragraphs [0017]-[0023]; and figure 2. | 1-3,5-11,13-15 |
| A | | 4,12 |
| Y | KR 10-2006-0110539 A (LG ELECTRONICS INC.) 25 October 2006 (2006-10-25) See paragraphs [0057]-[0060]; and figure 4. | 1-3,5-11,13-15 |
| A | KR 10-2006-0010168 A (PANTECH CO., LTD.) 02 February 2006 (2006-02-02) See paragraphs [0018]-[0033]; and figures 3-4. | 1-15 |
| A | KR 10-2000-0066140 A (HYUNDAI ELECTRONICS IND. CO., LTD.) 15 November 2000 (2000-11-15) See paragraphs [0048]-[0065]; and figure 2. | 1-15 |
| A | KR 10-2006-0007591 A (PANTECH CO., LTD.) 26 January 2006 (2006-01-26) See paragraphs [0022]-[0026]; and figure 5. | 1-15 |

☐ Further documents are listed in the continuation of Box C.　　☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **04 August 2023** | **04 August 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/005913**

| Patent document cited in search report | | | Publication date (day/month/year) | Patent family member(s) | | | Publication date (day/month/year) |
|---|---|---|---|---|---|---|---|
| KR | 10-2006-0021666 | A | 08 March 2006 | None | | | |
| KR | 10-2006-0110539 | A | 25 October 2006 | None | | | |
| KR | 10-2006-0010168 | A | 02 February 2006 | KR | 10-0623353 | B1 | 19 September 2006 |
| KR | 10-2000-0066140 | A | 15 November 2000 | KR | 10-0293147 | B1 | 15 June 2001 |
| KR | 10-2006-0007591 | A | 26 January 2006 | KR | 10-0572479 | B1 | 18 April 2006 |

Form PCT/ISA/210 (patent family annex) (July 2022)